(19) Europäisches Patentamt
European Patent Office
Office européen des brevets

(11) Numéro de publication: **0 380 166 A1**

# (12) DEMANDE DE BREVET EUROPEEN

(21) Numéro de dépôt: **90200129.6**

(22) Date de dépôt: **18.01.90**

(51) Int. Cl.5: **H03K 3/36, G11C 11/39, H03B 7/06**

(30) Priorité: **24.01.89 FR 8900811**

(43) Date de publication de la demande: **01.08.90 Bulletin 90/31**

(84) Etats contractants désignés: **DE FR GB IT**

(71) Demandeur: **LABORATOIRES D'ELECTRONIQUE PHILIPS**
**3, Avenue Descartes**
**F-94450 Limeil-Brévannes(FR)**
(84) **FR**

Demandeur: **N.V. Philips' Gloeilampenfabrieken**
**Groenewoudseweg 1**
**NL-5621 BA Eindhoven(NL)**
(84) **DE GB IT**

(72) Inventeur: **Delhaye, Etienne, Société Civile S.P.I.D.,**
**209 rue de l'Université**
**F-75007 Paris(FR)**
Inventeur: **Wolny, Michel, Société Civile S.P.I.D.,**
**209 rue de l'Université**
**F-75007 Paris(FR)**
Inventeur: **Aguila, Thierry, Société Civile S.P.I.D.,**
**209 rue de l'Université**
**F-75007 Paris(FR)**
Inventeur: **Pyndiah, Ramesh, Société Civile S.P.I.D.,**
**209 rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

## (54) Dispositif semiconducteur intégré incluant un transistor à effet de champ à grille isolée et polarisée en continu à un niveau élevé pour produire une zone de conductance différentielle négative de drain.

(57) Dispositif semiconducteur intégré incluant un transistor à effet de champ (T1) à grille isolée polarisée en continu à un niveau élevé de manière à obtenir pour le transistor une caractéristique de courant drain-source en fonction de la tension drain-source en forme de N et présentant une zone de conductance différentielle négative, caractérisé en ce qu'il comprend des moyens pour appliquer entre le drain et la source du transistor à effet de champ une tension dont la valeur est dans la zone des valeurs de tension drain-source correspondant à la zone de conductance négative.

Application : circuits numériques ou analogiques

VGS
T1

E
Rl
S
VE
VS

FIG. 4a

EP 0 380 166 A1

# DISPOSITIF SEMICONDUCTEUR INTEGRE INCLUANT UN TRANSISTOR A EFFET DE CHAMP A GRILLE ISOLEE ET POLARISEE EN CONTINU A UN NIVEAU ELEVE POUR PRODUIRE UNE ZONE DE CONDUCTANCE DIFFERENTIELLE NEGATIVE DE DRAIN

L'invention concerne un dispositif semiconducteur intégré incluant un transistor à effet de champ à grille isolée polarisée en continu à un niveau élevé de manière à obtenir pour le transistor une caractéristique de courant drain-source en fonction de la tension drain-source en forme de N et présentant une zone de conductance différentielle négative.

L'invention trouve son application dans la réalisation de circuits numériques et analogiques, par exemple des bascules bistables notamment pour des mémoires, ou encore par exemple des oscillateurs hyperfréquences.

L'invention trouve son application tout particulièrement dans les circuits intégrés réalisés au moyen de technologies mettant en oeuvre des matériaux semiconducteurs du groupe III-V.

Les propriétés d'un transistor à effet de champ à grille isolée sont connues par exemple de la publication intitulée "New Negative Resistance Regime of Heterostructure Insulated Gate Transistor Operation" par Michaël F.SHUR and alii, dans "IEEE Electron Device Letters, Vol.EDL-7, N° 2, February 1986".

Ce document décrit l'effet de résistance différentielle négative de drain qui apparaît dans un transistor à effet de champ présentant un canal de type de conduction N avec une hétérostructure GaAs-GaAlAs et une grille isolée, à polarisation de grille élevée et constante.

La structure de ce transistor, dit HIGFET, comprend une couche de GaAs non-intentionnellement dopée, d'épaisseur 0,5 $\mu$m, réalisée sur un substrat de GaAs semi-isolant, suivi d'une couche de GaAlAs non-intentionnellement dopée, comme couche d'isolation de grille, sur laquelle un contact de grille en WSi est réalisé. Des régions de source et drain sont délimitées de part et d'autre de la grille par implantation localisée d'ions Si pour des régions N ou Mg pour des régions P. Les contacts ohmiques sur ces régions lorsqu'elles sont de type N sont formés par des métallisations de Au-Ge-Ni. Le dispositif est isolé par implantation de protons. La grille présente une longueur de 1,3 $\mu$m et une largeur de 10 $\mu$m.

Avec ce dispositif, pour une tension grille-source fixe de valeur élevée, environ 3V, il apparaît une décroissance du courant drain-source lorsque la tension drain-source varie de 0,8 à 1,25 V. Puis, pour la même tension grille-source fixe, lorsque la tension drain-source varie de 1,25 V à des valeurs supérieures, le courant drain-source augmente. Ces variations du courant drain-source en fonction de la tension drain-source, à tension grille-source constante et élevée, conduisent donc à l'observation d'une résistance négative de drain en régime de saturation. Cet effet est dû à un transfert spatial des porteurs du canal collectés par la grille. Aucune application de cet effet n'est proposée dans le document cité.

Un but de l'invention est de proposer des circuits numériques ou analogiques plus simples que les circuits équivalents déjà connus de l'homme du métier.

Un autre but de l'invention est de proposer de tels circuits réalisés au moyen de composants actifs réalisables dans des technologies faciles à mettre en oeuvre.

Un autre but de l'invention est de proposer de tels circuits qui fonctionnent à température ambiante.

Un autre but de l'invention est de proposer de tels circuits dont les performances sont améliorées par rapport à des circuits équivalents connus de l'homme du métier.

Ces buts sont atteints au moyen d'un dispositif tel que décrit dans le préambule, caractérisé en ce qu'il comprend des moyens pour appliquer, entre le drain et la source du transistor à effet de champ à grille isolée, une tension dont la valeur est dans la zone des valeurs de tension drain-source correspondant à la zone de conductance négative.

L'avantage de ce circuit est qu'il est simple et qu'il fonctionne à température ambiante.

Dans une mise en oeuvre, ce dispositif est caractérisé en ce que, pour former une bascule bistable, la tension de polarisation continue de grille est fixe, et en ce que les moyens pour appliquer la tension voulue entre le drain et la source du transistor à effet de champ à grille isolée consistent d'une part en la liaison directe de la source à la masse, et d'autre part en la connexion du drain du transistor à effet de champ, à travers une charge résistive $R_\ell$, à une entrée E pour un signal numérique $V_E$ fournissant des impulsions de part et d'autre d'une valeur moyenne de la tension d'entrée, la valeur de la charge résistive $R_\ell$ et la valeur moyenne de la tension d'entrée étant choisies dans la zone des valeurs où le circuit formé a deux points de fonctionnement dus à la conductance différentielle négative de drain, résultant en un effet mémoire appliqué au signal de sortie numérique $V_S$ disponible sur le drain S du transistor à effet de champ.

Les avantages de ce circuit sont entre autres que le signal de sortie est plus stable que celui d'autres circuits connus, que la bascule n'a réellement que deux états, et qu'elle possède la fonction mémoire.

Dans une mise en oeuvre différente, ce dispositif est caractérisé en ce que, pour former un oscillateur, les moyens pour appliquer la tension voulue entre le drain et la source du transistor consistent d'une part en la liaison directe de la source à la masse, et d'autre part en un circuit L-C série disposé entre une alimentation continue $V_{DD}$ et la masse, respectivement par une extrémité de l'inductance L et par une extrémité de la capacité C, le point commun à l'inductance L et à la capacité C étant relié au drain du transistor à effet de champ sur lequel se fait la sortie S de l'oscillateur, la valeur de la tension $V_{DD}$ d'alimentation continue étant choisie pour que le transistor à effet de champ soit équivalent à une conductance négative reliée au circuit L-C.

Dans une variante de cette dernière mise en oeuvre, la tension $V_1$ de polarisation continue de grille du transistor à effet de champ peut être ajustable dans le domaine où le transistor présente une zone de conductance négative de drain, pour l'ajustage de la puissance de sortie de l'oscillateur.

Dans une autre variante, la capacité du circuit L-C peut être choisie d'un type variable en fonction d'une tension continue $V_2$, pour l'ajustage de la fréquence de fonctionnement de l'oscillateur.

L'avantage de ces circuits oscillateurs est qu'ils sont simples, réglables en fréquences, utilisables en hyperfréquences, et pouvant fournir en outre une puissance de sortie ajustable.

Différents transistors connus pour fournir une conductance négative de drain, peuvent être utilisés pour mettre en oeuvre le dispositif selon l'invention et d'une manière générale tout transistor à effet de champ c'est-à-dire unipolaire dont la grille est isolée du canal de conduction soit par un oxyde, soit par un matériau formant une hétérojonction avec la couche active, et dont le substrat est soit semi-isolant, soit conducteur, c'est-à-dire formé d'un matériau semiconducteur dopé.

L'invention sera mieux comprise au moyen de la description suivante illustrée par les figures annexées dont :

- la figure 1 qui représente un transistor à effet de champ à grille isolée, à hétérojonction ;
- les figures 2a à 2c qui représentent les niveaux d'énergie des bas des bandes de conduction des différents matériaux formant le transistor pour différentes valeurs de la tension de polarisation continue de grille $V_{GS}$ ;
- la figure 3a qui représente la caractéristique $I_{DS}$ en fonction de $V_{DS}$ à $V_{GS}$ constante et élevée ;

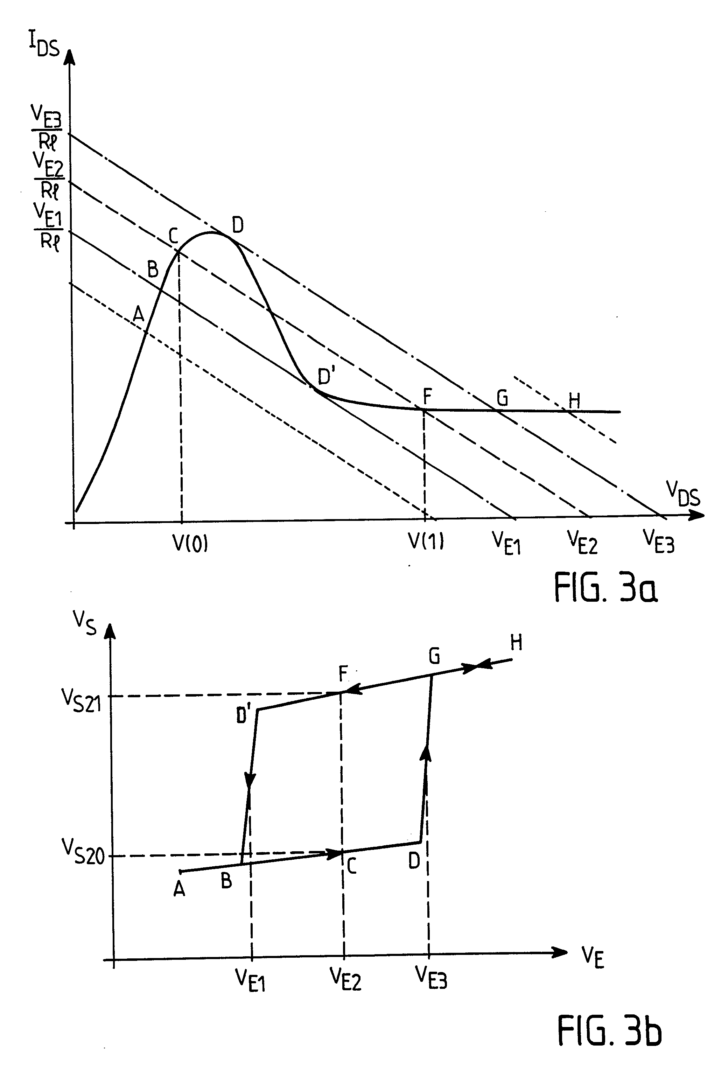

- la figure 3 b qui représente la courbe d'hystérésis due aux deux points de fonctionnement du circuit ;

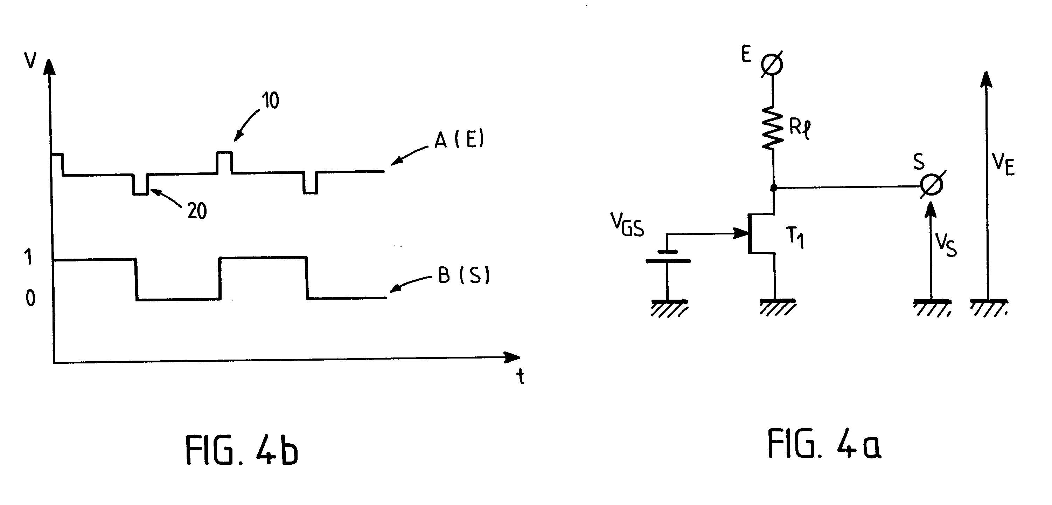

- la figure 4a qui montre le schéma du dispositif incluant un transistor à effet de champ à grille isolée approprié à former un circuit bistable selon l'invention ;
- la figure 4b qui montre le séquencement du signal d'entrée et du signal de sortie du circuit bistable ;

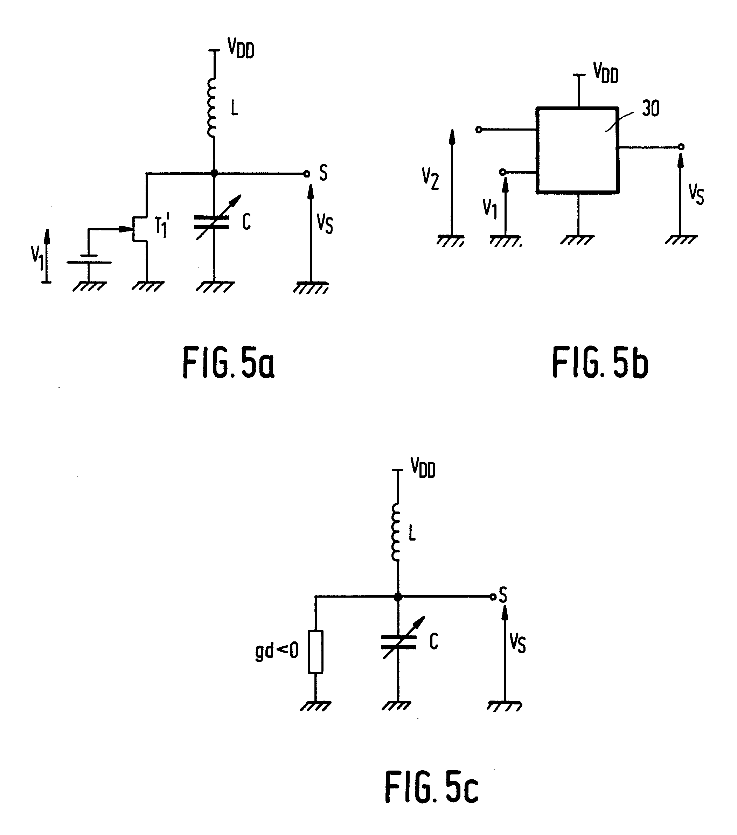

- la figure 5a qui montre un circuit oscillateur selon l'invention ;
- les figures 5b et 5c qui montrent des schémas équivalent à l'oscillateur selon l'invention ;
- la figure 6 qui montre la forme d'un signal obtenu au moyen d'un circuit oscillateur selon l'invention.

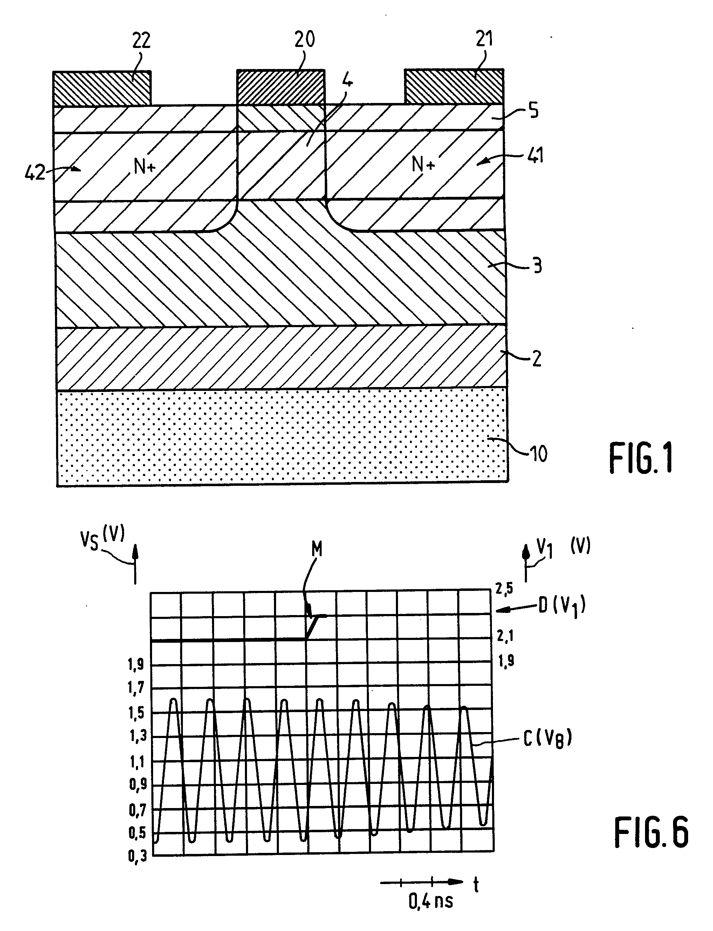

La figure 1 montre un transistor à effet de champ à grille isolée à hétérojonction de structure appropriée à la mise en oeuvre de l'invention. On verra plus loin que d'autres types de transistors à effet de champ à grille isolée peuvent aussi être utilisés.

Tel que représenté sur la figure 1, ce transistor comprend, réalisé sur un substrat binaire 10, une couche tampon binaire 2 puis une hétérostructure formée d'une couche binaire non-intentionnellement dopée 3, surmontée d'une couche ternaire non-intentionnellement dopée 4. La structure de ce transistor comprend aussi une couche supérieure de protection 5 en un matériau binaire non-intentionnellement dopé.

Les couches binaires seront favorablement en un composé semiconducteur du groupe III-V telles que l'arséniure de gallium (GaAs) et les couches ternaires en un composé semiconducteur du groupe III-V tel que l'arséniure de gallium et d'aluminium (GaAlAs).

Ce dispositif comporte aussi à sa surface supérieure un contact de grille 20, en un métal choisi favorablement parmi les métaux réfractaires tels que WN ou WSi ou bien en un semiconducteur très dopé, tel que l'arséniure de gallium fortement dopé.

Ce dispositif comporte en outre de part et d'autre de la grille 20, une électrode de source 21 et une électrode de drain 22 réalisées sur des caissons 41 et 42 fortement dopés qui délimitent les régions de source et de drain.

Un procédé de réalisation pour mettre en oeuvre un tel transistor est notamment connu de la publication citée au titre d'état de la technique ou de la publication intitulée "High Performance WN-Gate MISFETs fabricated from MOVPE Wafers", par M.WOLNY et alii dans "Electronics Letters, 8th October 1987, Vol.23, N° 21, pp.1127-1128".

Ce dernier document décrit un procédé de réalisation pour obtenir un transistor comprenant d'abord un substrat semi-isolant en GaAs, couvert d'une couche tampon en GaAlAs non-intentionnellement dopée. Ce transistor comprend ensuite une hétérostructure formée d'une couche d'épaisseur environ 0,6 µm de GaAs non-intentionnellement dopée, couverte d'une couche d'épaisseur environ 40 nm de GaAlAs non-intentionnellement dopée. Cette dernière couche est couverte d'une couche peu épaisse de GaAs non-intentionnellement dopée servant de couche protectrice pour empêcher l'oxydation de la couche supérieure de l'hétérostructure. En surface de la couche protectrice est réalisé un contact de grille en un métal réfractaire WN, de part et d'autre duquel des caissons de type $N^+$ délimitent les régions de source et de drain sur lesquelles sont établis des contacts ohmiques de source et drain en un alliage Au-Ge-Ni.

Ce transistor connu présente l'avantage d'être d'une réalisation simple et de performances élevées particulièrement favorables à la réalisation de la présente invention.

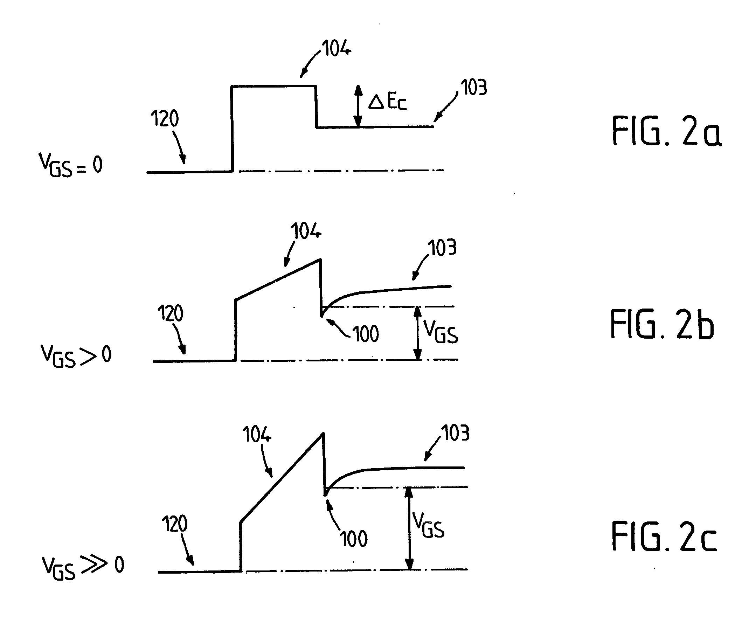

Les figures 2 représentent les niveaux d'énergie des bas des bandes de conduction des différents matériaux constituant les transistors, pour différentes valeurs de la tension de polarisation continue de grille $V_{GS}$.

La référence 120 montre le niveau d'énergie du métal de grille, la référence 104 celui du matériau 4 ternaire, et la référence 103 celui du matériau binaire 3 de l'hétérojonction. La valeur $\Delta E_c$ est la différence d'énergie entre le bas des bandes de conduction des matériaux 3 et 4 formant cette hétérojonction.

La figure 2a montre les niveaux d'énergie pour chacun des matériaux formant le transistor à $V_{GS} = 0$. Initialement, lorsque la polarisation de grille $V_{GS} = 0$, le niveau de Fermi est aligné avec celui du métal.

La figure 2b représente ces niveaux d'énergie lorsque la tension de polarisation de grille $V_{GS}$ est supérieure à 0. Cette figure montre que les bandes de conduction se déforment et qu'un puits de potentiel se forme au point 100. En 100, il y a accumulation d'un gaz bidimensionnel.

La figure 2c montre ces mêmes bandes lorsque la polarisation de grille $V_{GS}$ devient très supérieure à 0. Les bandes se déforment alors de telle manière que toute la tension est en fait aux bornes de la couche ternaire parce que le potentiel du point 100 n'évolue plus ou très peu. On est en effet dans le gaz bidimensionnel et en-dessous du niveau de Fermi. En conséquence, l'épaisseur apparente de la couche ternaire 4 diminue et il y a apparition d'un effet tunnel qui s'ajoute à l'émission thermoionique à l'interface des deux couches 3 et 4 formant l'hétérojonction.

En effet, dès que le gaz bidimensionnel existe, lorsque une tension drain-source est appliquée, des porteurs accélérés deviennent énergétiques, peuvent franchir la barrière d'énergie $\Delta E_c$ et sont collectés par la grille. Ainsi, quand on polarise fortement la grille par une tension $V_{GS}$ en direct, on observe une diminution du courant de drain, car lorsque l'on augmente $V_{DS}$, la barrière apparente pour les électrons s'affaiblit et la probabilité pour que ces électrons franchissent la barrière augmente fortement. Tous les électrons qui s'échappent du gaz bidimensionnel ne participent donc plus au courant de drain $I_{DS}$ et ce dernier diminue. On obtient alors une caractéristique du courant drain-source en fonction de la tension drain-source $V_{DS}$ telle que représentée sur la figure 3a. Il est important de noter que cette caractéristique présente une forme dite en N.

Sur cette figure 3a, la zone où le courant diminue au-delà du maximum D correspond à une région de résistance différentielle négative entre le drain et la source.

Le transistor $T_1$ décrit précédemment peut être polarisé dans des conditions favorables à l'obtention de cette région de résistance différentielle négative.

On décrit ci-après deux exemples de mise en oeuvre de moyens de polarisation pour appliquer entre le drain et la source de transistors à effet de champ à grille isolée une tension dont la valeur est dans la zone des valeurs de tension drain-source correspondant à la zone de conductance négative, ces deux exemples conduisant à des circuits ayant des fonctions différentes.

**Exemple I**

Dans cet exemple, illustré par les figures 3a, 3b, 4a et 4b, on décrit des moyens de planarisation d'un transistor à effet de champ, à grille isolée, pour obtenir un signal de sortie numérique $V_S$, à partir d'un signal numérique d'entrée $V_E$ qui fournit des impulsions de part et d'autre d'une valeur moyenne.

Le circuit selon l'invention a la fonction d'une bascule bistable (n'ayant réellement que deux états stables), dont le signal de sortie est très stable et présente une fonction mémoire.

Le circuit approprié à obtenir cet effet est montré schématiquement sur la figure 4a. Il comprend un transistor $T_1$, une résistance $R_\ell$ disposée entre le drain du transistor $T_1$ et l'entrée E pour le signal numérique $V_E$. La source du transistor $T_1$ est reliée directement à la masse. La grille du transistor $T_1$ est polarisée par une tension continue $V_{GS}$ fixe et suffisamment élevée pour produire l'effet illustré par la figure 2c et la caractéristique de la figure 3a.

La tension de grille $V_{GS}$ étant fixée à une valeur $V_{GS} = V_1$, la(les) valeur(s) de la tension de sortie

$V_S = V_{DS}$ est(sont) déterminée(s) par le(s) croisement(s) entre :
la caractéristique $I_{DS}$ en fonction de $V_{DS}$ du transistor et la droite $V_{DS} = V_E - R_\ell . I_{DS}$, dite droite de charge.

En effet le couple ($V_{DS}$, $I_{DS}$) doit satisfaire ces deux relations. Ces points ($V_{DS}$, $I_{DS}$) sont appelés point de fonctionnement du circuit.

Lorsque la valeur de la tension d'entrée numérique $V_E$, appliquée à l'extrémité de la résistance R, est inférieure à une valeur $V_{E1}$ repérée sur l'axe des abscisses de la figure 3a, le point de fonctionnement du montage est situé sur la caractéristique entre les points A et B. La tension de sortie du circuit telle que montré sur la figure 4a est $V_S$ prélevée entre le drain du transistor $T_1$ et la masse. Cette tension de sortie $V_S$ doit être lue sur l'axe des abscisses $V_{DS}$ de la figure 3b.

Si la valeur de la tension d'entrée augmente en passant de $V_{E1}$ à $V_{E3}$, le point de fonctionnement du circuit se déplace sur la caractéristique en allant de B vers C déterminés par les droites de charges :
$V_{DS} = V_{E1} - R_\ell I_{DS}$
et
$V_{DS} = V_{E2} - R_\ell I_{DS}$,
puis vers D qui est le maximum de la courbe correspondant à la droite de charge
$V_{DS} = V_{E3} - R_\ell . I_{DS}$.
Au-delà de la valeur $V_{E3}$, le point de fonctionnement se situe entre G et H. La transition de D se fait en G au voisinage de $V_{E3}$.

Lorsque la tension $V_E$ repasse de $V_{E3}$ à $V_{E1}$, les points de fonctionnement du montage passent de D′ vers D puis vers B et enfin vers A. Tout ceci se traduit sur la courbe de transfert du montage $V_S = f(V_E)$ par une hystérésis représentée sur la figure 3b. Cette courbe montre que pour une tension d'entrée $V_E = V_{E2}$, il existe deux points de fonctionnement représentés par les points C et F sur les figures 3a et 3b, l'un correspondant à un niveau 1 et l'autre à un niveau 0 pour la sortie du circuit.

Ainsi, lorsqu'un signal numérique tel que le signal représenté par la courbe A sur la figure 4b est appliqué à l'entrée E du circuit de la figure 4a, la forme de l'onde obtenue sur la sortie S entre drain et masse du circuit de la figure 4a sera de la forme de la courbe B de la figure 4b.

La figure 4b montre que 2 états stables $V_{S20}$ - (lire "$V_S$ deux-zéro") et $V_{S21}$ (lire "$V_S$ deux-un") sont obtenus pour un même niveau d'entrée $V_{E2}$. Un circuit bistable est donc réalisé au moyen du circuit de la figure 4a dans les conditions de polarisation qui ont été décrites précédemment.

Un tel circuit trouve son application dans la réalisation de points mémoires statiques, pour lequel l'écriture d'un 1 "logique" est effectuée en appliquant un créneau repéré par la référence 10 sur la courbe A de la figure 4b, et l'écriture d'un 0 en appliquant un créneau de type repéré par la référence 20 sur la courbe A de la figure 4b.

Pour chaque front de créneau 10, 20, ou impulsions autour de la valeur moyenne $V_{E2}$ de tension $V_E$, le signal de sortie $V_S$ change de niveau et passe du niveau 1 au niveau 0, ou l'inverse ; mais lorsque le signal d'entrée reprend la valeur moyenne $V_{E2}$, le signal de sortie $V_S$ garde l'information jusqu'à l'apparition d'un nouveau front de créneau ou impulsion 10, 20. Le circuit selon l'invention a donc la fonction de bascule bistable avec mémoire.

La très bonne stabilité du signal de sortie est obtenue du fait que la résistance R est reliée au drain du transistor à effet de champ, permettant d'appliquer le signal d'entrée à une de ses extrémités et de prélever le signal de sortie sur le drain à son autre extrémité, la source étant reliée directement à la masse.

Dans une réalisation préférentielle où le transistor $T_1$ est du type décrit précédemment et représenté schématiquement sur la figure 1 :
- la tension de polarisation de grille $V_{GS} = 2,8$ V ;
- la largeur de grille du transistor $T_1$, $W = 10 \mu m$ ;
- la résistance de charge $R_\ell = 1,8$ kΩ ;
- la tension d'entrée $V_E$ est entre 3 V et 4 V ;
- la tension de sortie $V_S$ est entre 0,5 V et 2 V.

Un point mémoire réalisé en utilisant la bascule selon l'invention est particulièrement avantageux car il ne comprend alors qu'un transistor, une charge résistive pour la bascule et un transistor d'accès. Il fonctionne à température ambiante et avec moitié moins de composants qu'il n'est connu à ce jour de l'homme du métier.

## Exemple II

Dans cet exemple illustré par les figures 3a, 5 et 6, on décrit des moyens de polarisation d'un transistor à grille isolée pour obtenir un circuit oscillateur hyperfréquences par exemple.

Tel que représenté sur la figure 5a, ce circuit comprend un transistor à effet de champ à grille isolée $T'_1$ dont la grille est polarisée par une tension continue $V_{GS} = V_1$, suffisamment élevée pour produire l'effet illustré par la figure 2c et par la caractéristique de la figure 3a. La source du transistor $T'_1$ est reliée directement à la masse.

Ce circuit comprend en outre un circuit L-C série, disposé entre une alimentation continue $V_{DD}$ à laquelle est reliée une extrémité de l'inductance L, et la masse à laquelle est reliée une extrémité de la capacité C, le noeud commun S à l'inductance L et à la capacité C étant relié au drain du transistor à effet de champ $T'_1$, sur lequel est disponible le signal de sortie $V_S$.

La valeur du niveau de la tension d'alimentation continue $V_{DD}$ est choisie pour que le transistor à effet de champ à grille isolée $T'_1$ soit équivalent à une conductance négative $g_d$. L'oscillateur obtenu est alors équivalent au schéma de la figure 5c, où $g_d < 0$.

La puissance de sortie de l'oscillateur représenté sur la figure 5c, est une fonction complexe et non linéaire de la conductance gd utilisée. Or la conductance négative $g_d$ est elle-même fonction de la polarisation $V_1$ de la grille du transistor à effet de champ à grille isolée, dans le cas du circuit selon l'invention (fig.5a), comme il apparaît en considérant la caractéristique de la figure 3a.

Il est donc possible, dans le circuit oscillateur représenté sur la figure 5a, de contrôler la puissance de sortie de l'oscillateur par l'intermédiaire de la tension de polarisation de grille $V_1$, cette dernière restant néanmoins dans la zone qui permet d'obtenir une région de conductance négative.

D'autre part, la fréquence de fonctionnement de l'oscillateur des figures 5 dépend des valeurs de l'inductance L et de la capacité C. Pour la réalisation d'un oscillateur contrôlé en tension (VCO, de l'anglais Voltage Controled Oscillator) on peut utiliser, pour réaliser la capacité C, une capacité réglable au moyen d'une tension, par exemple une varicap réglable au moyen d'une tension continue $V_2$. L'oscillateur 30 admet alors pour circuit équivalent le schéma représenté sur la figure 5b.

Dans le présent exemple de réalisation, pour obtenir un oscillateur hyperfréquences fonctionnant à la fréquence f = 20 GHz, on pourra réaliser les éléments avec les valeurs suivantes :

L = 0,5 nH
C = 0,1 pF
$V_1$ = 2,1 V
$V_{DD}$ = 1V
Le transistor $T'_1$ aura une longueur de grille $\ell$ = 1 µm
et une largeur de grille W = 10 µm
et sera du type décrit précédemment.

La figure 6 montre que l'oscillation à f = 20 GHz est facilement obtenue avec des éléments L-C aisément intégrables et des tensions compatibles avec des niveaux usuels dans les circuits intégrés.

Sur cette figure 6, la courbe C montre le signal de sortie $V_S$ prélevé sur le drain du transistor à effet de champ $T_1$, et la courbe D montre la tension de polarisation de grille $V_1$. On constate d'après la courbe D montrant $V_1$, que pour une variation référencée M de $V_1$ correspondant à une augmentation par exemple, on obtient une variation de la puissance de sortie qui se traduit ici par une diminution de l'amplitude de la courbe C.

Les transistors décrits dans les publications déjà citées ne sont pas les seuls à montrer un effet de résistance ou conductance négative de drain.

En fait tout transistor qui est à la fois du type à effet de champ (unipolaire) et à grille isolée peut être utilisé pour réaliser des circuits selon les exemples I et II. D'une manière générale, lorsque l'on applique sur la grille d'un de ces transistors une tension $V_{GS}$ élevée, on obtient une caractéristique $I_{DS}$ en fonction de $V_{DS}$ qui est de la forme en N montrée sur la figure 3a, et l'on peut, d'une part relier la source à la masse et d'autre part relier le drain à une tension ($V_E$ ou $V_{DD}$) au moyen d'un circuit de polarisation (RP ou L-C), de manière à ce que le circuit obtenu fonctionne dans la région de conductance négative de la figure 3a.

On citera à titre d'exemple de transistors à effet de champ à grille isolée qui peuvent être également utilisés :

a) les MOSFETs (de l'anglais Metal-Oxyde-Semiconductor-Field-Effect-Transistor). Dans des types de transistors, généralement réalisés sur silicium, la grille qui est métallique, est isolée de la couche active par une couche d'oxyde. La conductance négative de drain peut être obtenue du fait que des électrons quittent la couche active, traversent la couche d'oxyde par effet tunnel et sont captés par la grille lorsque cette dernière est polarisée à un niveau $V_1$ convenable.

b) Les HIGFETs (de l'anglais Heterostructure Insulated Gate Field Effect Transistor). Dans ce type de transistors, généralement réalisés en matériaux III-V, la grille est isolée de la couche active par une couche formant une hétérostructure avec la couche active. Dans cette catégorie, on trouve plusieurs sous-groupes de transistors qui peuvent permettre de mettre en oeuvre l'invention.

- les transistors dont le substrat est semi-isolant : dans ce cas l'effet de conductance négative de drain se produit du fait que les électrons du gaz bidimensionnel (voir plus haut) sont captés par la grille ;
- les transistors dont le substrat est conducteur par exemple formé d'un matériau semiconducteur dopé (par exemple dopé $N^+$). Dans ce cas la conductance négative de drain est obtenue par l'émission d'électrons chauds (en anglais Hot Electrons) vers le substrat conducteur et non vers la grille.

Dans le groupe des HIGFETs, la grille des transistors à effet de champ peut être réalisée de deux manières différentes. La grille peut être métallique pour les MISFETs (de l'anglais : Metal-Insulator-Semiconductor-Field-Effect Transistor), ou bien la grille peut être elle-même en un matériau semiconducteur pour les SISFETs (Semiconductor-Insulator-Semiconductor-Field-Effect-transistor).

Pour les électrons chauds, le matériau formant la grille est en fait indifférent et l'effet n'est pas changé.

Dans tout l'exposé précédent, on notera que l'on n'a pas cité comme aptes à une mise en oeuvre de l'invention les transistors à puits quantiques. Un tel transistor est par exemple connu de la demande EP 0 225 698. Dans un tel transistor bipolaire par exemple, le puits quantique disposé entre la base et l'émetteur possède des niveaux d'énergie discrets des porteurs. En modifiant la polarisation émetteur-base, on peut égaliser l'énergie des niveaux du puits avec celle du bas de la bande de conduction du matériau de l'émetteur. Par cette méthode, la caractéristique du courant de base en fonction de la tension base-émetteur présente un pic suivi d'une discontinuité. Il est dit que le circuit proposé peut permettre la réalisation d'une bascule bistable ou d'un diviseur de fréquences. Mais ce type de transistor à puits quantiques est extrêmement difficile à mettre en oeuvre sur le plan technologique, du fait de la faible épaisseur des couches nécessaires à la réalisation du puits quantique. D'autre part il ne fonctionne qu'à une température de 77° K, ce qui est un inconvénient rédhibitoire pour les applications grand public envisagées par exemple dans le domaine de la télévision. Enfin l'existence de la discontinuité due aux niveaux d'énergie discrets engendre des quantités d'inconvénients et notamment des instabilités. Par ailleurs, l'effet qui apparaît sur la caractéristique courant de base en fonction de la tension base-émetteur est complètement différent de l'effet de conductance négative de drain utilisé dans les dispositifs selon l'invention.

## Revendications

1. Dispositif semiconducteur intégré incluant un transistor à effet de champ à grille isolée polarisée en continu à un niveau élevé de manière à obtenir pour le transistor une caractéristique de courant drain-source en fonction de la tension drain-source en forme de N et présentant une zone de conductance différentielle négative, caractérisé en ce qu'il comprend des moyens pour appliquer entre le drain et la source du transistor à effet de champ une tension dont la valeur est dans la zone des valeurs de tension drain-source correspondant à la zone de conductance négative.

2. Dispositif selon la revendication 1, caractérisé en ce que, pour former une bascule bistable, la tension $V_{GS}$ de polarisation de grille est fixe, et en ce que les moyens pour appliquer la tension voulue entre le drain et la source du transistor à effet de champ à grille isolée consistent d'une part en la liaison directe de la source à la masse, et d'autre part en la connexion du drain du transistor à effet de champ à travers une charge résistive $R_\ell$, à une entrée E pour un signal numérique $V_E$ fournissant des impulsions de part et d'autre d'une valeur moyenne de la tension la valeur de la charge résistive $R_\ell$ et la valeur moyenne de la tension d'entrée étant choisies dans la zone des valeurs où le circuit formé à deux points de fonctionnement dus à la conductance différentielle négative de drain, résultant en un effet mémoire appliqué au signal de sortie numérique $V_S$ disponible sur le drain S du transistor à effet de champ.

3. Dispositif selon la revendication 1, caractérisé en ce que, pour former un oscillateur, les moyens pour appliquer la tension voulue entre le drain et la source du transistor à effet de champ à grille isolée consistent d'une part en la liaison directe de la source à la masse, et d'autre part, en un circuit L-C série disposé entre une alimentation continue $V_{DD}$ et la masse, respectivement par une extrémité de l'inductance et par une extrémité de la capacité C, le point commun à l'inductance L et à la capacité C étant relié au drain du transistor à effet de champ sur lequel se fait la sortie S de l'oscillateur, la valeur de la tension d'alimentation continue $V_{DD}$ étant choisie pour que le transistor à effet de champ à grille isolée soit équivalent à une conductance négative reliée au circuit L-C.

4. Dispositif selon la revendication 3, caractérisé en ce que la tension continue de polarisation de grille $V_{GS} = V_1$ est ajustable dans le domaine où le transistor présente une zone de conductance négative de drain, pour l'ajustage de la puissance de sortie de l'oscillateur.

5. Dispositif selon l'une des revendications 3 ou 4, caractérisé en ce que la capacité C du circuit L-C est d'un type variable en fonction d'une tension continue $V_2$, par exemple une varicap, pour l'ajustage de la fréquence de fonctionnement de l'oscillateur.

6. Dispositif selon l'une des revendications 1 à 5, caractérisé en ce que le transistor à effet de champ à grille isolée est du type à grille isolée du canal par une couche d'oxyde.

7. Dispositif selon l'une des revendications 1 à 5, caractérisé en ce que la couche d'isolation de grille forme une hétérostructure avec la couche formant le canal du transistor à effet de champ à grille isolée.

8. Dispositif selon la revendication 7, caractérisé en ce que la grille du transistor à effet de champ à grille isolée est métallique.

9. Dispositif selon la revendication 7, caractérisé en ce que la grille du transistor à effet de champ à grille isolée est en un matériau semiconducteur.

10. Dispositif selon l'une des revendications 7 à 9, caractérisé en ce que le substrat du transistor à effet de champ à grille isolée est semi-isolant.

11. Dispositif selon l'une des revendications 7 à 9, caractérisé en ce que le substrat du transistor à effet de champ à grille isolée est conducteur, par exemple formé d'un matériau semiconducteur dopé.

22
20
21
4
5
42
N+
N+
41
3
2
10

FIG.1

VS (V)
M
V1 (V)
2,5
D (V1)
2,1
1,9
1,9
1,7
1,5
1,3
1,1
0,9
0,7
0,5
0,3
C (V8)
t
0,4 ns

FIG.6

FIG. 2a
FIG. 2b
FIG. 2c
104
103
ΔEc
120
VGS = 0
100
VGS
VGS > 0
VGS >> 0

$I_{DS}$
$\frac{V_{E3}}{R\ell}$
$\frac{V_{E2}}{R\ell}$
$\frac{V_{E1}}{R\ell}$
A
B
C
D
D'
F
G
H
$V_{DS}$
V(0)
V(1)
$V_{E1}$
$V_{E2}$
$V_{E3}$
FIG. 3a
$V_S$
$V_{S21}$
$V_{S20}$
A
B
C
D
D'
F
G
H
$V_E$
$V_{E1}$
$V_{E2}$
$V_{E3}$
FIG. 3b

E
$R_\ell$
$T_1$
S
$V_S$
$V_E$
$V_{GS}$
A (E)
B (S)
10
20
V
1
0
t

FIG. 4a

FIG. 4b

VDD
L
S
T1'
C
VS
V1

FIG.5a

VDD
30
V2
V1
VS

FIG.5b

VDD
L
S
gd<0
C
VS

FIG.5c

Office européen des brevets

# RAPPORT DE RECHERCHE EUROPEENNE

Numero de la demande

EP 90 20 0129

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,X | IEEE ELECTRON DEVICE LETTERS, vol. EDL-7, no. 2, février 1986, pages 78-80, IEEE, New York, US; M.S. SHUR et al.: "New negative resistance regime of Heterostructure Insulated Gate Transistor (HIGFET) operation" * Page 78, colonne de gauche, dernière alinéa, colonne de droite, alinéa 3; figure 3 * --- | 1 | H 03 K 3/36<br>G 11 C 11/39<br>H 03 B 7/06 |
| A | IBM TECHNICAL DISCLOSURE BULLETIN, vol. 24, no. 1A, juin 1981, pages 82-84, New York, US; M. AV-RON et al.: "FET logic device" * Page 84, alinéa 2; figures 1,4,5 * --- | 1,2 | |
| D,A | ELECTRONICS LETTERS, vol. 23, no. 21, 8 octobre 1987, pages 1127-1128, Hitchin, GB; M. WOLNY et al.: "High-performance WN-gate MISFETs fabricated from MOVPE wafers" * Page 1127, colonne de gauche, alinéa 2 - colonne de droite, alinéa 1; figure 1 * --- | 7,8,10, 11 | **DOMAINES TECHNIQUES RECHERCHES (Int. Cl.5)** |
| D,A | HIGH SPEED ELECTRONICS: BASIC PHYSICAL PHENOMENA AND DEVICE PRINCIPLES-PROCEEDINGS OF THE INTERNATIONAL CONFERENCE, Stockholm, 7-9 août 1986, pages 140-143, Springer Verlag, Berlin, DE; D.J. FRANK et al.: "Excess gate current due to hot electrons in GaAs-gate FETs" ----- | | H 03 K<br>H 01 L |

Le présent rapport a été établi pour toutes les revendications

| Lieu de la recherche | Date d'achèvement de la recherche | Examinateur |
|---|---|---|
| LA HAYE | 10-04-1990 | BLAAS D.-L.A.J. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)